# EUROPEAN PATENT APPLICATION

(11) **EP 2 363 373 A1**
(43) Date of publication of application: **07.09.2011**
(21) Application number: 10155251.1
(22) Date of filing: 02.03.2010
(51) Int. Cl.: B81C 1/00

(54) **Bonding process for sensitive micro-and nano-systems**

(71) Applicant: SensoNor Technologies AS, 3192 Horten (NO)
(72) Inventor: Elfving, Anders, N-3192, Horten (NO); Hoivik, Nils, N-3192, Horten (NO); Stark, Birger, N-3192, Horten (NO); Wang, Kaiying, N-3192, Horten (NO)
(74) Representative: Haley, Stephen

(57) **Abstract**

A metal inter-diffusion bonding method comprises providing a stack of a first metal on a surface of both a first wafer and second wafer to be joined together. Said first metal is susceptible to oxidation in air. A layer of a second metal is provided on the first metal and has a melting point lower than that of the first metal. On the top surface of each stack of first metal is the layer of second metal sufficiently thick to both inhibit oxidation of the top surface of the first metal and to ensure that unreacted Sn remains when partners are brought together. A bond is initiated between the first and second wafers by bringing the layers of the second metal on each wafer into contact at a bonding temperature that is below the melting point of the second metal, by applying a bonding force that is sufficient to initiate inter-diffusion at an interface between the layers of the second metal. The bonding temperature is increased whilst applying the bonding force to achieve a desired inter-diffusion at the bond interface, thereby bonding the first and second wafers together, and no pre-treatment of the wafers is required prior to bonding.

## Description

The present invention relates to an inter-diffusion method for bonding micro and nano-structures, and in particular a method for 3D integration, as well as packaging, of sensitive and fragile structures or components typically performed at, but not limited to, wafer level.

A challenge when developing sensitive structures, such as micro-electromechanical systems (MEMS) and MEMS based devices, is that nearly all new MEMS devices require a specially designed package to protect the sensitive and delicate components within, as discussed in US7132721. Consequently, it is desirable to be able to provide packaging at wafer-level and, furthermore, to provide a bonding process capable of handling mass production of MEMS and the packaging of MEMS devices.

US7132721 teaches a process wherein a first material is deposited on a first wafer surface and a second material is deposited on a second wafer surface, the two wafer surfaces being pressed together to effect a bond, wherein inter-diffusion between the first and second materials forms an alloy compound which then holds the wafers together.

A problem with this method, however, is that depositing different material combinations on each wafer can increase irregularities and non-uniformities on the wafer bonding surface across the wafer. Furthermore, deposited material that is susceptible to oxidation will require a pre-treatment to remove any oxide before the materials can be bonded. Such pre-treatment is very undesirable when manufacturing MEMS devices containing sensitive and delicate components, which may become damaged during the oxide removal process.

A further problem with existing methods of bonding is the temperatures applied during bonding. Solid liquid inter-diffusion (SLID) technology is a well known inter-diffusion bonding method, which originates from chip-to-wafer processes for 3D microsystem integration. A typical implementation of this technology uses a first and a second metal, wherein the first metal has a higher melting point than the second metal, may be susceptible to oxidization in air to form a native oxide. An example is Cu-Sn SLID bonding, wherein Cu is easily oxidized in air and has a much higher melting point than Sn.

The problem is that in existing SLID chip-to-wafer processes, where chips are attached individually to the wafer, the typical maximum bonding temperature used exceeds the melting point of the second metal, which prevents the presence of both the first and second metals on the wafer surface since diffusion of the first metal into the second metal would lead to a compound being formed extending all the way to the bonding surface, before all the dies are assembled, which is undesirable. Therefore, only the first metal is deposited on the wafer surface while both metals are deposited on the chip surface. An alternative chip-to-wafer process, described in US6872464, is based on assembly at low temperature followed by a high-temperature reflow process. However, the low-temperature pre-bond is achieved using a soldering agent based on a thermoplastic polymer.

Furthermore, if the surface of the first metal is easily oxidized in air it forms a native oxide on the surface, which reduces wetting and acts as a barrier to prevent intermixing between the first and second metals when the wafer and chip are brought into contact. Any oxide on the surface of the first metal must therefore be prevented from forming, or removed, using a flux procedure, preferably performed in-situ during assembling of the system, rather than ex-situ, to prevent oxidation, which can occur quickly. Some examples of chemicals commonly used in such procedures are hydrochloric acid, sulphuric acid, vapor formic acid, or forming gas.

While the acids used are the most effective oxide removers, however, they also have a significant negative impact on sensitive micro- or nanostructures on the two samples to be bonded together. Consequently, it is generally not feasible to perform surface treatment in combination with delicate structures such as MEMS components, thin film metal conductors or dielectrics.

Furthermore, most simple surface treatment procedures are most effective at temperatures near the melting point of the second metal. After in-situ treatments, the bonding surfaces will therefore be brought into contact under pressure at relatively high temperatures followed by an immediate ramp-up to a temperature above the melting point of the second metal. This may result in a large volume of the second metal melting which will lead to undesired squeeze and flow to the surroundings. This can in turn cause, for example, electrical shortcuts and there is also the risk that any unreacted second metal will re-melt during high temperature post-processes such as getter activation and lead-free soldering.

According to the present invention there is provided a metal inter-diffusion bonding method, comprising the steps of:
providing a stack of a first metal on a surface of both a first wafer and second wafer to be joined together, said first metal being susceptible to oxidation in air;
providing a layer of a second metal, having a melting point lower than that of the first metal, on the top surface of each stack of first metal, the layer of second metal being sufficiently thick to inhibit oxidation of the top surface of the first metal
initiating a bond between the first and second wafers by bringing the layers of the second metal on each wafer into contact at a bonding temperature that is below the melting point of the second metal,
controlling the bonding parameters to achieve a desired inter-diffusion at the bond interface, thereby initiating bonding of the first and second wafers, that thereafter proceeds to an intermetallic bond interface
wherein no pre-treatment that maintain, secure or enhance wetting and solderability, of the wafers is required prior to bonding.

Accordingly, the present invention provides a bonding method that enables metal bonding for devices having delicate and sensitive components which, for many applications, require hermetic sealing, with or without vacuum cavities. Using the method of the present invention, bonding, and 3D integration, can be performed at wafer-level on wafers that are unable to withstand flux procedures, or other treatment, that are usually required to remove surface oxides or prevent oxidation of bonding surfaces.

An advantage with the present invention is that without the pre-treatment requirement of the bonding surfaces, the wafers can be brought into contact at low temperature. This provides a more uniform temperature distribution throughout the wafer stack at an early stage of the process, since both wafers are in thermal contact with the temperature regulated bonding chucks.

A further advantage of the present invention is that most intermetallics are formed below the melting point of the second metal, when compared with existing SLID processes, thereby reducing the volume of liquid materials present during the process.

Accordingly, the present invention provides a method for metal bonding on wafer level, without the requirement for any surface treatment, where two bonding metals provided on each wafer are used to form a final compound via intermetallic formation.

In addition to forming part of the final bond, the second metal, having the lower melting point, also acts as a protective layer on top of the first metal on both of the components to be bonded together. This allows for longer storage periods of fabricated bonding partners than for samples with exposed first metal surfaces which will be oxidized.

Without the second metal as a protection layer, the first metal surface is covered with a native oxide which prevents wetting and inter-diffusion of the two metals during the bonding process, and therefore requiring either removal - by etching, or using a reduction process, which is potentially damaging to the delicate components.

The present invention provides a flux-free bonding process, which is also free from any other surface pre-treatments such as pre-annealing or use of a soldering agent and is therefore compatible with delicate micro- and nano-scale electromechanical devices, thin film metal conductors or dielectric surfaces, in particular after they are released and left free-standing.

The bonding pressure applied on the wafers when assembled is sufficiently high, for example >0.05 MPa, or more specifically in the range 5 MPa to 50 MPa, such that non-uniformities across the wafer can be absorbed by the second, more ductile, metal applied to both surfaces. The wetting condition of the bonding surfaces is also enhanced due to the bonding surfaces being of the same metal.

An example of the present invention will now be described with reference to the following figures, in which:
Figure 1 shows two wafers, prepared according to the present invention, prior to bonding;
Figure 2a shows the wafers of Figure 1 as they are initially brought together;
Figure 2b is a graph of time vs. temperature relating to the bonding process stage in figure 2a;
Figure 3a shows an inter-diffusion bond region forming between two surfaces when the temperature is raised;
Figure 3b is a graph of time vs. temperature relating to the bonding process stage in figure 3a;
Figure 4a shows the final compound formation after the bond is formed; and
Figure 4b is a graph of time vs. temperature relating to the bonding process stage in figure 4a.

Although in this example of the present invention, the first metal is Copper (Cu) and the second metal is Tin (Sn), it will be understood by a person skilled in the art that other combinations of suitable metals, wherein the metal with the higher melting point oxidizes in air to form a thick native oxide, such as, but not limited to, Silver (Ag) or Nickel (Ni), can be used. Furthermore, the examples herein discuss a silicon wafer or substrate, but it will be appreciated that the wafer or substrate may include other materials like, but are not limited to, Ge, glass, quartz, SiC and/or III-V semiconductors.

A stack of Cu 3, with a thickness typically ranging between 1-10µm, is patterned on a surface of a top wafer 1, in this example a Si wafer. A layer of Sn 4 is then deposited on top of the Cu stack 3. The Sn layer 4 is sufficiently thick to both prevent oxidation of the surface of the Cu stack 3 and to ensure that unreacted Sn remains when partners are brought together, in this example having a thickness greater than 0.5µm. For an inter-diffusion process to complete, the ratio of Cu to Sn must be greater than 1.3 in order to guarantee complete transformation to a resulting Cu₃Sn compound 7 in the solidified bond.

The Sn does not only form part of the final metal compound, but also protects the Cu from oxidation such that the wafer 1, 2 can be stored over long periods of time between deposition and assembling processes.

In this particular example, the Cu and Sn pattern deposited on the surface of the top wafer 1 defines a boundary around a recess 5 that has been formed in the top wafer 1. Cu and Sn are also deposited on a bottom wafer 2 using a similar configuration with preferably, but not necessarily, identical thicknesses and lateral geometries as for the top wafer.

The bottom wafer 2 is shown having a number of delicate components 8 provided on it for illustrative purposes. Of course, such components 8 may be provided on the bottom wafer and/or top wafer, depending on the purpose of the structure.

Deposition can, for example, be performed using either electro-plating, or electroless-plating, starting from appropriate seed layers, or by any other means of deposition method, as well known in the art.

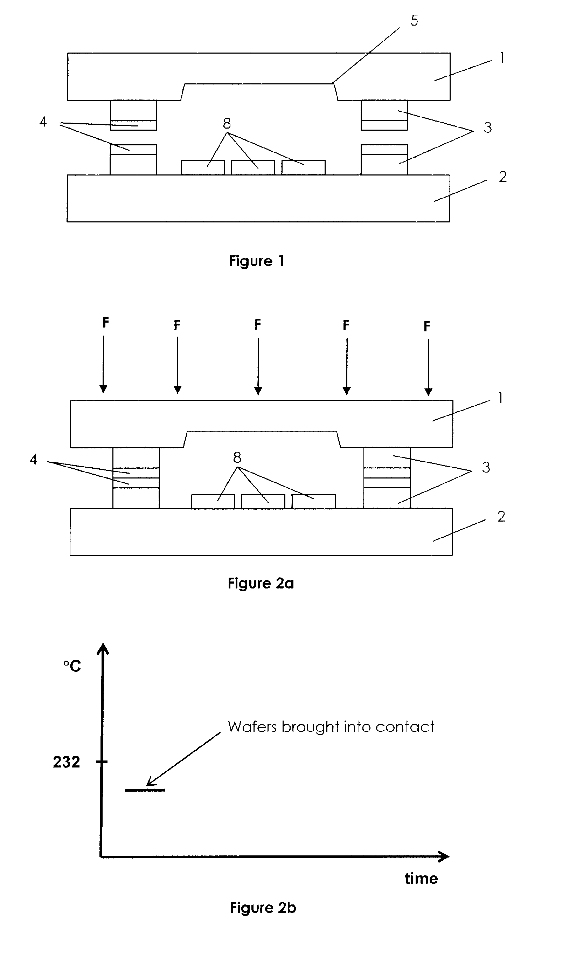

Figure 2a shows the top and bottom wafers 1, 2 as they are initially brought into contact to initiate the bonding process under bonding force F. This step of the process is performed below the melting temperature of Sn, as indicated in the graph shown in Figure 2b. Furthermore, this step can also be performed at relatively low temperatures when compared with existing SLID methods, even at room temperature, if necessary. However, the temperature at which the wafers are brought together will depend on the final application intended for the bonding process - such as vacuum encapsulation or hermetic sealing, as will be understood by a person skilled in the art.

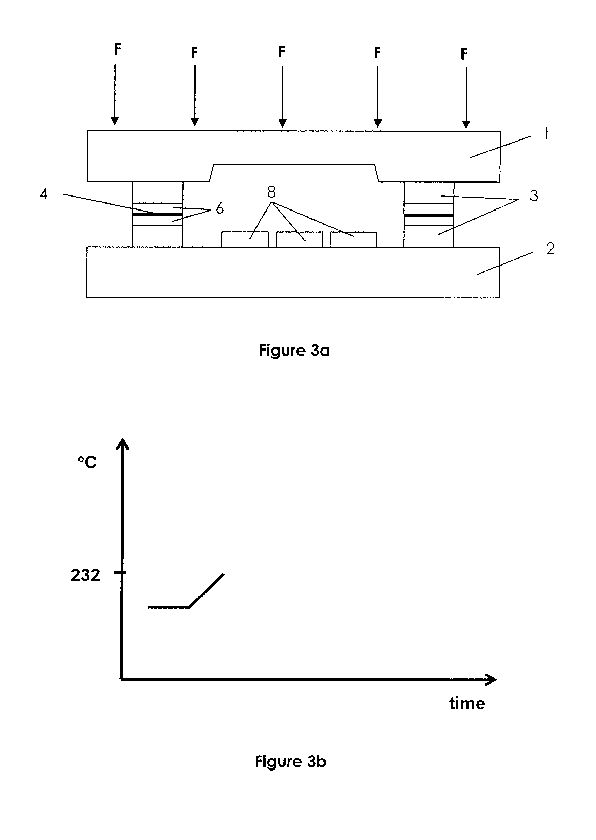

As shown in Figure 3a, bringing the top and bottom wafers 1, 2 together under pressure at a temperature below the melting point of Sn, as shown in Figure 3b, facilitates an intimate metallic contact between the Sn/Sn interface with the Sn layers 4 being squeezed together under, in this example, a bonding pressure provided by the bonding force, F. The bonding force lead to Sn deformation, breaking up contamination layer and smoothing out surface asperity, which further can be enhanced by the application of ultrasonic energy. Heat accelerate interatomic diffusion, thus the Sn-Sn bond formation, but also the intermetallic formation growing from the Cu/Sn interfaces, leaving only a small amount, if any, of pure Sn 4 in between when exceeding its melting temperature, depending on temperature profile and metal thicknesses. The intermetallics consists of Cu₆Sn₅ at temperatures below 150 degC, being gradually converted to Cu₃Sn at higher temperatures when excess Cu is present.

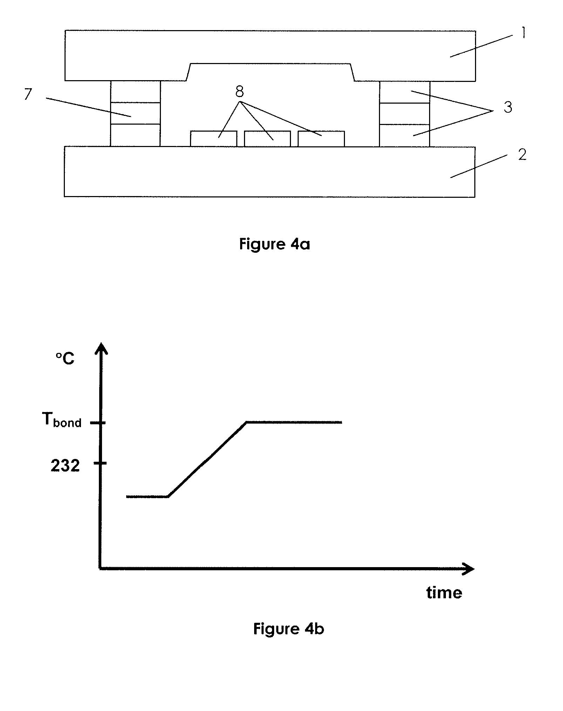

Figure 4a shows the resulting CuₓSn_{y} alloy compound 7, which composition depends on the temperature at the Cu-Sn interface, but it is preferably Cu₃Sn in this particular example. In this example, the bonding process is completed at a temperature exceeding the melting point of Sn, as can be seen from the temperature profile shown in Figure 4b. The temperature profile must be tuned to ensure that all of the Sn 4 is converted into the desired CuₓSn_{y} compound.

In Figure 4b a constant increase in temperature is shown. However, the increase may not be constant, and may be varied both below and above the Sn melting point, which is approximately 232°C. This can have benefits in terms of controlling bonding. As mentioned above, however, it is possible to achieve a good intermediate metallic Sn/Sn bond and at the same time reduce the residual volume of unreacted Sn left at the bonding interface with a proper temperature profile before reaching its melting point

Accordingly, the present invention could be regarded as a solid state process, wherein an intermediate compound 6 and/or resulting CuₓSn_{y} compound 7 phases are formed without necessarily relying on liquidation of the pure Sn 4, since both Cu₆Sn₅ and Cu₃Sn phases have melting points higher than melting temperature of Sn and the maximum bonding temperature. Depending on how the process is set up, the liquid Sn phase may not exist at all, or can be limited to a very narrow region near the Sn/Sn interface.

The bonding force applied on the wafers 1, 2 when being joined is high enough to allow the Sn on both bonding surfaces to make intimate contact, and thus any non-uniformities across the wafer 1, 2 can be absorbed by the ductile Sn. Having a Sn layer 4 on both mating surfaces can further improve the total Sn thickness uniformity compared to state of the art processes. It is also possible to compensate for non-uniformities on one of the wafers by using a modified layout on the other wafer. This could, for example, include mirrored individual dummy structures on the two wafers 1, 2.

In this example, the temperature profile has been selected such that significant interdiffusion of Cu and Sn occurs below the 232°C melting point of Sn, as can be seen from Figure 3b. This approach facilitates having no or only a small volume of unreacted Sn remaining at the Sn/Sn interface when the melting point of Sn is reached. Accordingly, since very limited, if any, melted material is present during the bonding process, any uncontrolled out-flow of molten Sn is thereby efficiently minimized. Figure 4a shows the resulting Cu₃Sn bond formed above the melting point for Sn, as shown in Figure 4b. As mentioned above other applications may require other CuₓSn_{y} compositions.
Beneficially, the sample does not need to be held above the melting temperature of Sn for long time since a majority of the inter-diffusion process has occurred at lower temperatures.

Any thickness non-uniformities across the wafers 1, 2 are absorbed by the ductile Sn during the process by exerting a large bonding force on the wafers during temperature ramping.

In another example of the present invention, CuSn bonding structures can be used for 3D interconnects. Flux-less assembling on wafer level can be performed by deposition of a Cu and Sn layer configuration of both wafers, similar to that described above. The structures in this example are designed as individual contacts. In this case, Sn flow can also be minimized by allowing for Cu-Sn/Sn-Cu interdiffusion below 232°C.

Both examples described above are suitable for high volume production using conventional wafer-level processes and, furthermore, can be combined together on the same wafer.

Advantageously, with the method of the present invention, none of the bonding surfaces of the second metal, having the lower melting point, need to be treated with flux prior to, or during, bonding. Furthermore, hermetic seals on wafer level can be accomplished with a flux-less process and bonding parameters can be optimized to limit Sn flow when joining the wafers together by tuning the temperature profile and force when compared with existing methods, where flux is required.

Although the example given is for wafer-level bonding, a skilled person will appreciate that the same principles apply for chip-level bonding of sensitive and delicate components that would otherwise be damaged using a method requiring a pre-treatment to the bonding surfaces before bonding.

The present invention therefore provides a SLID-type bonding method at wafer level, suitable for bonding sensitive structures, which may contain fragile components, without any type of pre-treatment of the separated wafers..

## Claims

1. A metal inter-diffusion bonding method, comprising the steps of:
providing a stack of a first metal on a surface of both a first wafer and second wafer to be joined together, said first metal being susceptible to oxidation in air;
providing a layer of a second metal, having a melting point lower than that of the first metal, on the top surface of each stack of first metal, the layer of second metal being sufficiently thick to inhibit oxidation of the top surface of the first metal
initiating a bond between the first and second wafers by bringing the layers of the second metal on each wafer into contact at a bonding temperature that is below the melting point of the second metal,
controlling the bonding parameters to achieve a desired inter-diffusion at the bond interface, thereby initiating bonding of the first and second wafers, that thereafter proceeds to an intermetallic bond interface
wherein no pre-treatment that maintain, secure or enhance wetting and solderability, of the wafers is required prior to bonding.

2. The method of claim 1, wherein the temperature does not exceed the melting point of the second metal during the bonding process

3. The method of claim 1 or 2, wherein the first metal is Copper and the second metal is Tin.

4. The method of claims 1 to 3, wherein during control of the bonding temperature the bonding temperature is increased in a constant manner.

5. The method of claims 1 to 3, wherein during control of the bonding temperature the bonding temperature is increased in a non-constant manner.

6. The method of any preceding claim, wherein the external bonding parameters is at least one of force, temperature or sonic energy,

7. A structure, comprising a first wafer and a second wafer joined together by forming an intermetallic compound, said compound being formed by an inter-diffusion between a first metal, which is susceptible to oxidation in air, and a second metal, having a lower melting point than the first metal, the first and second metals being provided on both the first and second wafers and arranged, prior to bonding, such that a layer of second metal is provided on a stack of the first metal, the layer of second material being sufficiently thick to both prevent oxidation of the first metal and to ensure that unreacted second metal remains when the wafers are brought together, the structure being such that the intermetallic compound has an intermetallic bond interface.

8. The structure of claim 7, wherein the first metal is Copper and the second metal is Tin.
